# EUROPEAN PATENT APPLICATION

(11) **EP 4 523 954 A1**
(43) Date of publication of application: **19.03.2025**
(21) Application number: 23803545.5
(22) Date of filing: 09.05.2023
(51) Int. Cl.: B60L 58/10, B60L 3/00, B60L 50/60, B60L 53/65, B60L 53/80, B60L 58/16, G06Q 10/04, H01M 10/48, H02J 13/00

(54) **VEHICLE BATTERY ASSESSMENT SYSTEM**

(30) Priority: 13.05.2022 JP 2022079294
(71) Applicant: DENSO CORPORATION, Kariya-city, Aichi 448-8661 (JP)
(72) Inventor: ASAI Tomomi, Kariya- city, Aichi 4488661 (JP); KUSANO Yoshikazu, Kariya- city, Aichi 4488661 (JP); YAMAMOTO Nobuo, Kariya- city, Aichi 4488661 (JP); SUZUKI Shogo, Kariya- city, Aichi 4488661 (JP); SUZUKI Hiroyasu, Kariya- city, Aichi 4488661 (JP); GOTO Keisuke, Kariya- city, Aichi 4488661 (JP)
(74) Representative: TBK
(86) International application number: PCT/JP2023/017350
(87) International publication number: WO 2023/219068

(57) **Abstract**

A vehicle battery assessment system (1) is for assessing a remaining life of a battery (11) installed in a vehicle (10). The vehicle battery assessment system (1) includes an information acquisition unit (101), a learned model acquisition unit (103), a remaining life assessment unit (105), and an assessment result output unit (106). The information acquisition unit (101) acquires at least vehicle information of the vehicle and usage history information of the battery (11). The learned model acquisition unit (103) acquires a learned model that is created in advance by setting at least the vehicle information of the vehicle (10) installed with the battery (11) and the usage history information of the battery (11) as explanatory variables, and the remaining life of the battery (11) as a target variable. The remaining life assessment unit (105) assesses the remaining life of the battery (11) based on the vehicle information and the usage history information acquired by the information acquisition unit (101) and the learned model. The assessment result output unit (106) outputs the assessment result of the remaining life assessment unit (105).

## Description

### CROSS REFERENCE TO RELATED APPLICATION

This application is based on Japanese Patent Application No. 2022-079294 filed on May 13, 2022, the disclosure of which is incorporated herein by reference.

### TECHNICAL FIELD

The present disclosure relates to a vehicle battery assessment system.

### BACKGROUND ART

Conventionally, as a configuration for assessing and checking a life of a battery installed in a vehicle, for example, Patent Literature 1 discloses a configuration in which deterioration states of multiple battery units that constitute a battery installed in a vehicle are assessed, and based on the deterioration states, remaining lives of the battery units are displayed on multiple screens so that each of a vehicle manufacturer, a dealer, a vehicle user, and the like can each check it.

### PRIOR ART LITERATURES

### PATENT LITERATURE

Patent Literature 1: JP 2010-111276 A

### SUMMARY

The configuration disclosed in Patent Literature 1 uses battery voltages and resistance values of the battery units to assess the deterioration states in a short period of time, but does not take into account vehicle information including how the vehicle is used, such as an area in which the vehicle installed with the battery is used and a mileage of the vehicle. As a result, the accuracy of deterioration information is low, and the accuracy of the assessment of the remaining life is also low. Therefore, there is room for improvement in assessing a remaining life with high accuracy.

The present disclosure provides a vehicle battery assessment system capable of assessing a life of a battery installed in a vehicle with high accuracy.

An aspect of the present disclosure is a vehicle battery assessment system for assessing a remaining life of a battery installed in a vehicle. The vehicle battery assessment system includes an information acquisition unit configured to acquire information including at least vehicle information of the vehicle and usage history information of the battery, a learned model acquisition unit configured to acquire a learned model that is created in advance by setting at least the vehicle information of the vehicle installed with the battery and the usage history information of the battery as explanatory variables and setting the remaining life of the battery as a target variable, a remaining life assessment unit configured to assess the remaining life of the battery based on the vehicle information and the usage history information acquired by the information acquisition unit and the learned model, and an assessment result output unit configured to output an assessment result of the remaining life assessment unit.

In the vehicle battery assessment system described above, the remaining life of the battery installed in the vehicle is assessed based on at least the vehicle information of the vehicle installed with the battery, the usage history information of the battery, and the learned model created in advance. Accordingly, it is possible to assess the remaining life of the battery with high accuracy in a short period of time.

As described above, according to the above aspect, it is possible to provide the vehicle battery assessment system capable of assessing the remaining life of the battery installed in the vehicle with high accuracy.

The reference numerals in parentheses described in claims indicate the correspondence relationship with specific means described in embodiments described later, and do not limit the technical scope of the present disclosure.

### BRIEF DESCRIPTION OF DRAWINGS

The above and other objects, features and advantages of the present disclosure will become more apparent from the following detailed description made with reference to the accompanying drawings. In the drawings:
FIG. 1 is a block diagram showing a configuration of a vehicle battery assessment system according to a first embodiment;
FIG. 2 is a conceptual diagram showing a feature space of a learned model in the first embodiment;
FIG. 3 is a conceptual diagram showing the relationship between the amount of collected batteries, a rebuilding order estimation, and a stock target in the first embodiment;
FIG. 4 is a flow diagram of a preliminary determination process in the first embodiment;
FIG. 5 is a flow diagram of a post preliminary determination process in the first embodiment;
FIG. 6 is a flow diagram of a model update process in the first embodiment;
FIG. 7 is a flow diagram of a stock update process in the first embodiment;
FIG. 8 is a flow diagram of a remaining life assessment process and a rebuilding process in the first embodiment; and
FIG. 9 is a flowchart of an association process in the first embodiment.

### DESCRIPTION OF EMBODIMENTS

### (First Embodiment)

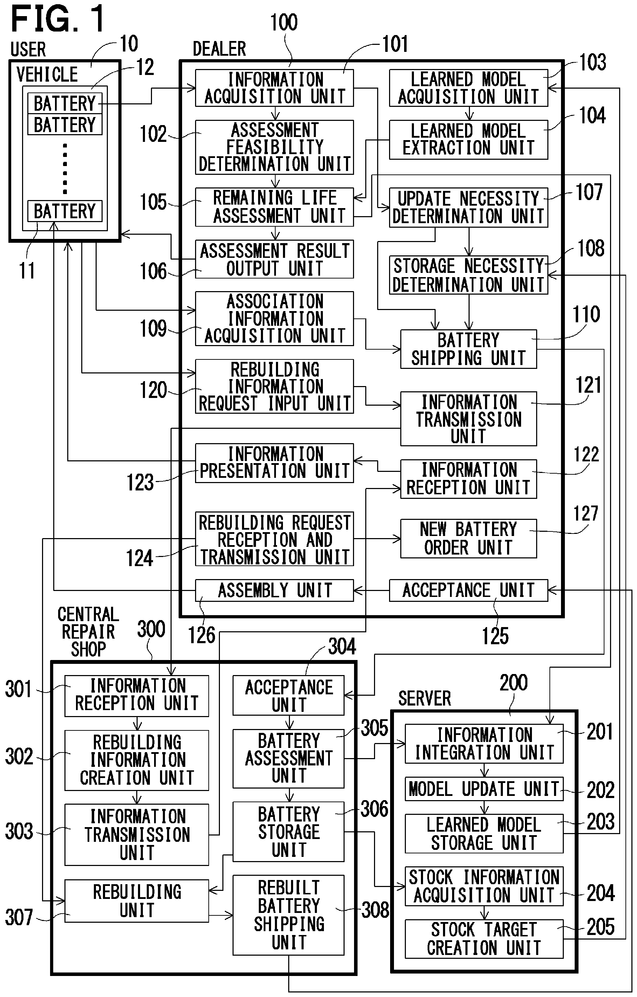

An embodiment of a vehicle battery assessment system will be described with reference to FIGS. 1 to 9. A vehicle battery assessment system 1 of a first embodiment is for assessing a remaining life of a battery 11 installed in a vehicle 10. As shown in FIG. 1, the vehicle battery assessment system 1 includes an information acquisition unit 101, a learned model acquisition unit 103, a remaining life assessment unit 105, and an assessment result output unit 106. The information acquisition unit 101 acquires at least vehicle information of the vehicle and usage history information of the battery 11. The learned model acquisition unit 103 acquires a learned model that has been created in advance by setting at least the vehicle information of the vehicle 10 installed with the battery 11 and the usage history information of the battery 11 as explanatory variables, and setting the remaining life of the battery 11 as a target variable. The remaining life assessment unit 105 assesses the remaining life of the battery 11 based on the vehicle information and the usage history information acquired by the information acquisition unit 101 and the learned model. The assessment result output unit 106 outputs the assessment result of the remaining life assessment unit 105.

The vehicle battery assessment system 1 of the present embodiment will be described in detail below.

### 1. Configuration of Vehicle Battery Assessment System 1

In the first embodiment, the vehicle battery assessment system 1 is configured to include a dealer 100, a server 200, and a central repair shop 300, as shown in FIG. 1. In addition, each component is not necessarily limited to be provided in the dealer 100, the server 200, and the central repair shop 300 shown in FIG. 1, and each component may be provided in any of the dealer 100, the server 200, and the central repair shop 300. Furthermore, all of the components constituting the vehicle battery assessment system 1 are not limited to be provided in the dealer 100, the server 200 and the central repair shop 300, but may be provided in a terminal or cloud connected via communication means.

The battery 11 that is a subject of an assessment by the vehicle battery assessment system 1 is installed in the vehicle 10 owned by a user. The battery 11 is a rechargeable secondary battery, and includes a battery composed of a single cell or a plurality of cells. A battery pack 12 is formed by electrically connecting a plurality of batteries 11 to each other. Each of the batteries 11 constitutes a module that can be individually attached to and detached from the battery pack 12. The battery 11 is not limited to a specific type as a secondary battery, and any battery suitable for the vehicle 10 can be adopted.

### 1-1. About Dealer 100

As shown in FIG. 1, the dealer 100 includes the information acquisition unit 101, an assessment feasibility determination unit 102, the learned model acquisition unit 103, a learned model extraction unit 104, the remaining life assessment unit 105, the assessment result output unit 106, an update necessity determination unit 107, a storage necessity determination unit 108, an association information acquisition unit 109, a battery shipping unit 110, a rebuilding information request input unit 120, an information transmission unit 121, an information reception unit 122, an information presentation unit 123, a rebuilding request reception and transmission unit 124, an acceptance unit 125, and an assembly unit 126. Among these units, the battery shipping unit 110 can be configured by a shipping system not shown, the information presentation unit 123 can be configured by a display device (not shown), and the other units can be configured by one or more processors (not shown).

The information acquisition unit 101 at least the vehicle information of the vehicle 10 and the usage history information of the battery 11. In the first embodiment, the information acquisition unit 101 further acquires battery characteristics of the battery 11. First, the vehicle information is information related to the vehicle 10, and examples of the vehicle information include a model, a date of manufacture, a period of use, a mileage, and an area of use of the vehicle 10. The date of manufacture does not necessarily have to be specified down to the day, but may be specified down to the year or the month. The vehicle information can be acquired from a storage device (not shown) provided in the vehicle 10.

The usage history information of the battery 11 may be maximum values, minimum values, average values, cumulative values, and the like over a predetermined period, such as the charging and discharging of the battery 11, a battery temperature, a battery voltage, capacity, SOC (state of charge), or a usage period of an apparatus in which the battery 11 is installed. The predetermined period can be any period up to the present, and may be the entire period from the manufacture of the secondary battery to the present. The usage history information of the battery 11 can be obtained from a BMU (Battery Management Unit) provided in the battery 11. The battery characteristics of the battery 11 include information on the current battery temperature, the current battery voltage, the current capacity, the current SOC, the current internal resistance, and the like of the battery 11. These can also be obtained from the BMU provided in the battery 11.

Typically, the information acquisition unit 101 acquires the above-described information from the battery 11 installed in the vehicle 10 brought to the dealer 100 by the user. Therefore, among the battery information obtained from the battery 11, the battery temperature and other battery information will not typically be the same values among a plurality of batteries 11 installed in the vehicle 10, and will typically include values that are different from each other.

Next, the assessment feasibility determination unit 102 determines whether an assessment of the remaining life of the battery 11 is feasible based on the above-described information acquired by the information acquisition unit 101. For example, if the SOC, the voltage, or a remaining capacity of the battery 11 is below a predetermined value, or if the internal resistance, the number of charge/discharge cycles, the date of manufacture of the vehicle 10, the period of use, or the mileage is above a predetermined value, the assessment feasibility determination unit 102 can determine that the assessment of the battery 11 is not feasible.

In addition, the assessment feasibility determination unit 102 may determine whether the assessment of the battery 11 is feasible based on whether the above-described information acquired by the information acquisition unit 101 is included in a valid range of the learned model that is preset in the learned model acquired by the learned model acquisition unit 103 described below. The valid range of the learned model can be set, for example, based on training data of each learned model. For example, in a data group of training data for each learned model, the valid range is a range in which a data distance from a data center is within a predetermined reference value. If it is determined for the above-described information acquired by the information acquisition unit 101 that any of data distances from each data center in the training data of multiple learned models is within a predetermined reference value, it can be determined that the assessment is feasible, and if not, it can be determined that the assessment is not feasible. The assessment feasibility determination unit 102 can determine whether the assessment is feasible after the learned model extraction unit 104 extracts the learned model, or can perform the determination simultaneously with the learned model extraction unit 104 extracting the learned model.

The battery 11 for which the assessment feasibility determination unit 102 determines that assessment is not feasible is obviously not reusable even without the need for assessment described below, so an arithmetic load can be reduced by eliminating the battery 11 before the assessment described below is performed. The battery 11 for which it is determined that the assessment is not feasible can be discarded or disassembled to recycle parts.

The learned model acquisition unit 103 acquires the learned model from the server 200 described below. In the learned model, the above-described information acquired by the information acquisition unit 101 is set as the explanatory variables and the remaining life of the battery 11 is set as the target variable. The learned model can be created using machine learning with training data. The learned model can be updated by operating the vehicle battery assessment system 1 of the first embodiment as described below. Then, the learned model acquisition unit 103 can acquire the latest learned model that is updated. In addition, multiple learned models can be prepared as described below, and in the first embodiment, the learned model acquisition unit 103 acquires multiple learned models.

The learned model extraction unit 104 extracts the optimal model from the multiple learned models acquired by the learned model acquisition unit 103. The extraction can be performed based on the information acquired by the information acquisition unit 101. For example, if the battery temperature in the information acquired by the information acquisition unit 101 is lower than a predetermined reference value, a learned model corresponding to the battery temperature can be extracted. For example, if the average value of the battery temperature history is lower than a predetermined reference value, or if the frequency of the battery temperature history at low temperatures is high, it can be estimated that the battery 11 was used in a cold region, and the learned model acquisition unit 103 can extract a learned model corresponding to this estimation. If the information acquired by the information acquisition unit 101 indicates that the battery 11 is of a specific vehicle model, a learned model corresponding to that specific vehicle model can be extracted. The learned model can be extracted based on the data distance between the information acquired by the information acquisition unit 101 and each data center in the data group of training data for each learned model.

The remaining life assessment unit 105 assesses the remaining life of the battery 11 for which the assessment feasibility determination unit 102 determines that the assessment is feasible, based on the above-described information acquired by the information acquisition unit 101 and the learned model. In the first embodiment, the optimal learned model extracted by the learned model extraction unit 104 is used as the learned model. Accordingly, the remaining life can be assessed with higher accuracy. The assessment result of the remaining life assessment unit 105 is stored in an information integration unit 201 of the server 200, which will be described later. The information integration unit 201 may store information for each of the batteries 11 that have been assessed, and may store the above-described information acquired by the information acquisition unit 101 for each of the batteries 11 together with the assessment result of the remaining life.

The assessment result output unit 106 outputs the assessment result by the remaining life assessment unit 105. An output form is not limited, and the assessment result may be displayed on a display unit, may be printed on paper, or may be notified by voice. Output contents may include other items in addition to the remaining life. The output contents for the user and the output contents for the dealer may be different. For example, the remaining life of the battery 11 along with other detailed information may be displayed to the dealer while only the necessity of replacement of the battery 11 is displayed to the user.

The update necessity determination unit 107 determines whether the battery 11 is necessary for updating the learned model stored in the server 200 described later. Although the criteria used by the update necessity determination unit 107 are not limited, in the first embodiment, it is determined that the update is necessary when any one of the following four criteria is satisfied.

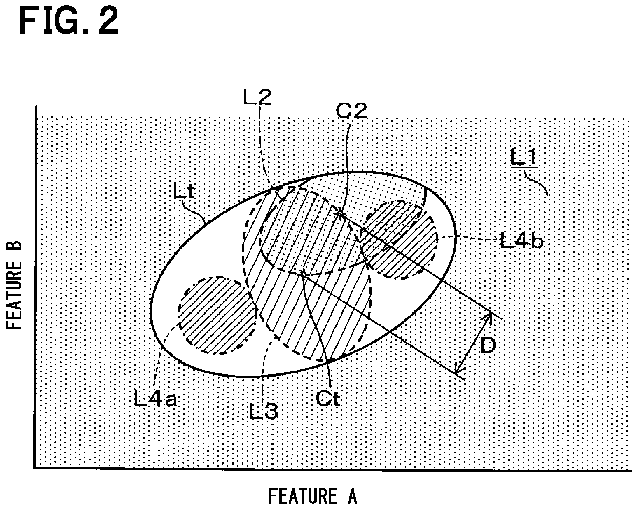

A first update criterion is whether the above-described information acquired by the information acquisition unit 101 for the battery 11 is information belonging to an unlearned domain in the latest learned model stored in a learned model storage unit 203 of the server 200. For example, in the learned model shown in FIG. 2, in a feature space defined by feature A and feature B in the training data, it is determined whether the information is in an unlearned domain L1, which is an unknown range other than a learned domain Lt, which is a known range in the training data. The learned domain Lt is within a predetermined distance from a center position Ct in a data space of the training data used in the latest learned model, and the other range is the unlearned domain L1. The distance between data can be defined based on the Mahalanobis distance, the Euclidean distance, the Manhattan distance, the Chebyshev distance, and the like.

A second update criterion is whether the information belongs to the learned domain Lt in the learned model, and a data distance between a data center calculated from information within a predetermined period from the latest model update and a data center calculated from all information in the learned domain Lt is equal to or greater than a reference value. For example, as shown in FIG. 2, it is determined whether a data distance D between a data center C2 in a data space of a data range L2 of N=100 training data most recently added to the latest learned model and a data center Ct of all the training data in the latest learned model is equal to or greater than a reference value.

A third update criterion is whether the information belongs to the leaning domain Lt in the learned model, and a difference between a data distortion calculated from information within a predetermined period from the latest model update and a data distortion calculated from all the information in the learned domain Lt is equal to or greater than a reference value. For example, as shown in FIG. 2, it is determined whether a difference between a data distortion in a data space of a data range L3 of N=100 training data most recently added to the latest learned model and a data distortion calculated from all the information in the learned domain Lt is equal to or greater than a reference value. The data distortion can be calculated, for example, based on a degree of deformation of an outer shape of a data range in a data space where the data distance D from the data center Ct of all the training data is within a reference value.

A fourth update criterion is whether the information belongs to the learned domain Lt in the learned model, and a difference between a data density calculated from information within a predetermined period from the latest model update and a data density calculated from all the information in the learned domain Lt is equal to or greater than a reference value. For example, as shown in FIG. 2, it is determined whether a difference between a data density in a data space of data ranges L4a and L4b of N=100 training data most recently added to the latest learned model and a data density calculated from all the information in the learned domain Lt is equal to or greater than a reference value. The data density can be calculated, for example, as the number of data items present per unit area of a target data range in the data space.

The update necessity determination unit 107 determines that an update of the learned model is necessary if the information acquired by the information acquisition unit 101 satisfies any of the first to fourth update criteria.

The storage necessity determination unit 108 determines whether the battery 11 needs to be stored for rebuilding at the central repair shop 300 described below. The term "rebuilding" refers to packing used assembled batteries into a used battery pack for reuse. For example, at the central repair shop 300, used assembled batteries are disassembled into modules or cells, and are stored in a warehouse after being stratified according to ranks assigned based on the degree of deterioration and the like, and the modules or cells corresponding to the required rank are extracted from the warehouse, reassembled, and packed, thereby rebuilding the assembled batteries. It is not necessary to disassemble and separate used assembled batteries. Instead, a battery stack, which is an assembly of the battery cells or modules, can be made by removing a circuit boards, a wiring, and a casing, and the battery stack can be used as is in a new pack to rebuild an assembled battery.

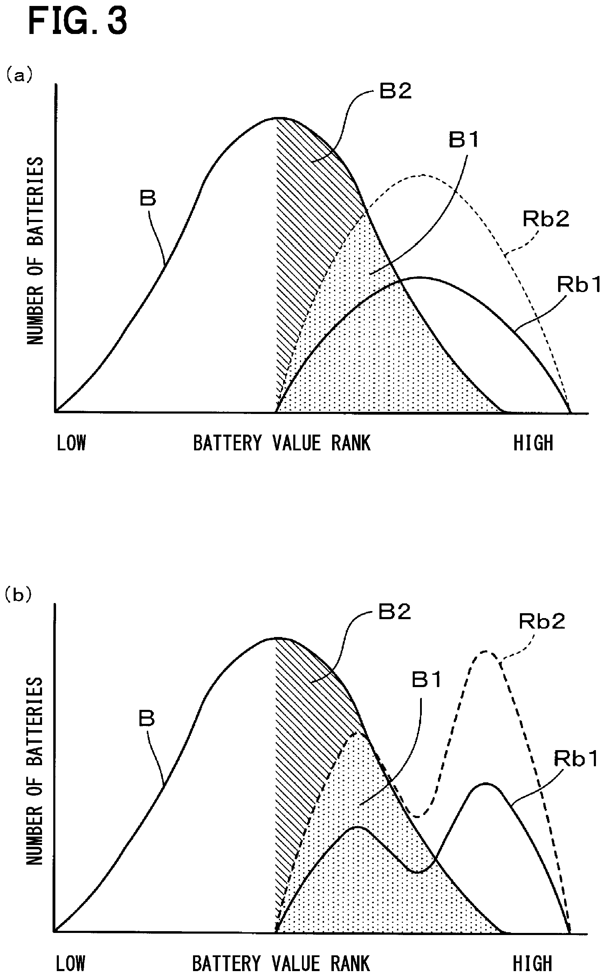

A storage criterion for rebuilding, which is a determination criterion in the storage necessity determination unit 108, is defined based on a stock target received from the server 200, which will be described later. For example, in an example shown in (a) in FIG. 3, a relationship between the number of collected batteries 11 and values, for example, capacities of the batteries 11 is shown as collected batteries B. A relationship between the number of batteries estimated to be required for rebuilding within a predetermined period in the future and a value rank can be shown by a rebuilding order estimation Rb1. A storage target Rb2 is set as the number with a certain degree of leeway corresponding to the rebuilding order estimation Rb1. In addition, in a relationship between the stock target Rb2 and the collected batteries B, whether the battery falls within a region B1 surrounded by the stock target Rb2, the collected batteries B, and the horizontal axis is the storage criterion for rebuilding in the storage necessity determination unit 108.

Based on the storage criterion for rebuilding, batteries 11 that fall within the region B1 are determined to need to be stored for rebuilding, while batteries 11 that do not fall within the region B1 are determined not to need to be stored. In particular, in (a) of FIG. 3, among the collected batteries B, batteries 11 that fall within a region B2 above the storage target Rb2 on the page are determined to be surplus batteries and therefore not to need to be stored for rebuilding. It should be noted that, in cases where there are multiple uses for the batteries 11, the rebuilding order estimation Rb1 may accordingly have a shape with multiple peaks in the graph showing the relationship between the value rank and the number of batteries. For example, as shown in the example of (b) in FIG. 3, the rebuilding order estimation Rb1 has two peaks, and correspondingly, the storage target Rb2 also has two peaks. In this case as well, the storage criterion for rebuilding is defined based on the storage target Rb2, similarly to the case of (a) in FIG. 3.

As described below, in the first embodiment, the batteries stored in the battery storage unit 306 in the central repair shop 300 are ranked based on the assessment results of the batteries 11, and the stock information includes the number of batteries for each rank. Based on this, the storage criterion for rebuilding also stipulate the number of batteries for each rank. In other words, the storage criterion for rebuilding is determined based on the stock status in the battery storage unit 306 and the assessment results of the batteries 11.

The association information acquisition unit 109 compares the battery information acquired by the information acquisition unit 101 from the battery 11 in a state of being installed in the vehicle with the battery information acquired from the battery 11 in a state of being removed from the vehicle, confirms that both are acquired from the same battery 11, and then acquires association information which is information that associates these with battery identification information of the battery 11. The form of the battery identification information is not limited, and may be a number, a symbol, a one-dimensional barcode, a two-dimensional barcode, or a combination of these.

The battery information in the association information may be, for example, a battery voltage of the battery 11. The association information acquisition unit 109 may acquire the association information immediately after removal from the vehicle 10, or may acquire the association information a predetermined period of time after removal from the vehicle 10. When acquiring the association information after the predetermined period of time has elapsed, the battery information in the association information can be corrected taking into account changes in the battery information over time, and the association information can be acquired using the corrected data.

The battery shipping unit 110 ships the battery 11 to the central repair shop 300, which will be described later. The battery 11 to be shipped is one that has been determined by the update necessity determination unit 107 as being necessary for updating the learned model, and one that has been determined by the storage necessity determination unit 108 as being necessary to be stored for rebuilding.

Next, the rebuilding information request input unit 120 allows the user to input a rebuilding information request after checking the output result of the assessment result output unit 106, for example, whether the battery 11 needs to be replaced, if the user requests information regarding rebuilding of the battery pack 12 of the vehicle 10. When the rebuilding information request is input, the information transmission unit 121 transmits the input result to the central repair shop 300 described below. Then, the information reception unit 122 receives rebuilding information transmitted from the central repair shop 300, which will be described below, and the received information is presented to the user by the information presentation unit 123. The information can be presented by displaying it on a display unit (not shown), printing it on paper, or notifying it by voice. The rebuilding information includes information such as a delivery time and a cost in the case of rebuilding. In addition, a delivery time and a cost of parts required to replace the battery 11 may also be included.

If the user checks the rebuilding information and then requests a rebuilt battery pack, the rebuilding request reception and transmission unit 124 receives the rebuilding request and transmits the request to the central repair shop 300. The acceptance unit 125 accepts a rebuilt battery pack shipped from the central repair shop 300, and the assembly unit 126 incorporates the rebuilt battery pack into the battery pack 12 of the user. Then, the battery pack 12 is installed in the vehicle 10. If the user requests to replace the battery with a new battery rather than a rebuilt battery, the rebuilding request reception and transmission unit 124 can receive this request and place an order for the new battery via a new battery order unit 127.

### 1-2. About Server 200

As shown in FIG. 1, the server 200 is connected to the dealer 100 and the central repair shop 300 described below via network lines. The server 200 can be provided on a cloud via an internet line. The server 200 includes an information integration unit 201, a model update unit 202, the learned model storage unit 203, a stock information acquisition unit 204, and a stock target creation unit 205. These components can be configured by one or more processors (not shown).

The information integration unit 201 integrates the information acquired by the information acquisition unit 101 of the dealer 100, the assessment results of the remaining life assessment unit 105, and assessment results of a battery assessment unit 305 in the central repair shop 300 described below.

The model update unit 202 updates the learned model based on the information from the information integration unit 201. The updated learned model is stored in the learned model storage unit 203. The learned model can be a model created by machine learning with setting the information acquired by the information acquisition unit 101 as the explanatory variable and setting the remaining life as the target variable. As the learned model, a prediction model such as a regression equation can be used, and for example, linear regression, Lasso regression, Ridge regression, decision tree, and support vector regression can be used. It is also possible to configure a neural network or XGBoost (eXtreme Gradient Boosting / gradient boosting regression tree).

The stock information acquisition unit 204 acquires stock information on batteries 11 stored as rebuilt batteries 11 in a battery storage unit 306 in the central repair shop 300 described below. The stock target creation unit 205 creates the storage target based on rebuilding order prediction within a predetermined period. The stock target can be created, for example, as shown in the examples of FIG. 3.

### 1-3. About Central Repair Shop 300

The central repair shop 300 performs repairs upon request from a plurality of dealers 100. The central repair shop 300 includes an information reception unit 301, a rebuilding information creation unit 302, an information transmission unit 303, an acceptance unit 304, the battery assessment unit 305, the battery storage unit 306, a rebuilding unit 307, and a rebuilt battery shipping unit 308. Of these units, the information reception unit 301, the rebuilding information creation unit 302, the information transmission unit 303, the acceptance unit 304 and the battery assessment unit 305 can be configured by a processor (not shown).

The information reception unit 301 receives input information of the rebuilding request transmitted from the information transmission unit 121 of the dealer 100. The rebuilding information creation unit 302 creates the rebuilding information, including the delivery date and the cost of the rebuilt battery, in response to the input information of the rebuilding request. The created rebuilding information is transmitted by the information transmission unit 303 to the dealer 100 and received by the information reception unit 122.

The acceptance unit 304 accepts the battery 11 shipped by the battery shipping unit 110 of the dealer 100. The received battery 11 is assessed by the battery assessment unit 305. The assessment by the battery assessment unit 305 is more detailed than the assessment by the remaining life assessment unit 105 of the dealer 100 and includes more assessment items. In order to improve the accuracy of the assessment, it is also possible to carry out the assessment after the temperature of the battery 11 is set to a predetermined state. Therefore, it takes more time to obtain the assessment results than the assessment by the remaining life assessment unit 105 at the dealer 100. The assessment method used by the battery assessment unit 305 is not limited, and any method capable of performing detailed assessment may be used. For example, battery characteristics relating to a transition of a battery state over a specified voltage range can be acquired for the battery 11, and the degree of deterioration can be determined based on the battery characteristics or a battery characteristic relation value calculated based on the battery characteristics, and the value of the battery 11 can be evaluated and ranked.

The battery storage unit 306 is configured as a warehouse where the batteries 11 can be stored. A storage status of the batteries 11 in the battery storage unit 306, that is, stock information including the number of stored batteries 11 and battery information of these batteries 11, is transmitted to the server 200 and acquired by the stock information acquisition unit 204. In the first embodiment, the batteries 11 are stored in the battery storage unit 306 in a predetermined ranked state based on the assessment results by the battery assessment unit 305. The stock information also includes information on the number of batteries for each rank.

The rebuilding unit 307 receives the rebuilding request from the rebuilding request reception and transmission unit 124 of the dealer 100, and rebuilds the battery in accordance with the request. The rebuilt battery is then shipped to the dealer 100 by the rebuilt battery shipping unit 308 and accepted by the acceptance unit 125.

### 2. Control Flow of Vehicle Battery Assessment System 1

### 2-1. Preliminary Determination Process

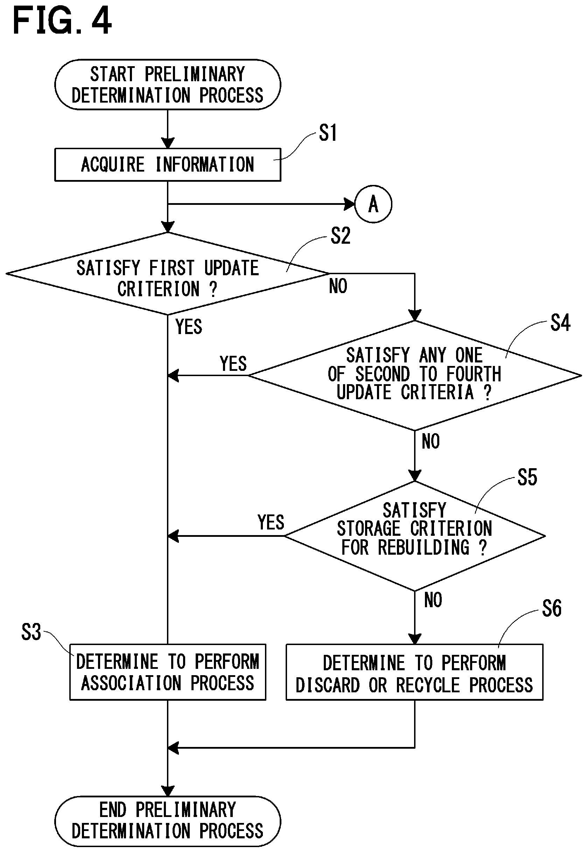

Next, in a control flow of the vehicle battery assessment system 1, first, a preliminary determination process shown in FIG. 4 will be described. In the preliminary determination process, in step S1 shown in FIG. 4, the information acquisition unit 101 of the dealer 100 acquires the vehicle information of the vehicle 10, the usage history information of the battery 11, and the voltage of the battery 11 as the battery characteristic. The acquired information is stored in the information integration unit 201 of the server 200.

Thereafter, in step S2, the update necessity determination unit 107 determines whether the information acquired by the information acquisition unit 101 satisfies the first update criterion. If it is determined that the acquired information satisfies the first update criterion, that is, if it is determined that the acquired information is information belonging to the unlearned domain L1 in the latest learned model stored in the learned model storage unit 203 of the server 200, the process proceeds to Yes in step S2, and it is determined in step S3 that the association process is to be performed, and the preliminary determination process is ended.

On the other hand, in step S2, if the update necessity determination unit 107 of the dealer 100 determines that the information acquired by the information acquisition unit 101 does not satisfy the first update criterion, the process proceeds to No in step S2, and in step S4, it is determined whether the information acquired by the information acquisition unit 101 satisfies any one of the second to fourth update criteria described above. If it is determined that the acquired information satisfies any one of the second to fourth update criteria, the process proceeds to Yes in step S4, it is determined in the above-described step S3 that the association process is to be performed, and the preliminary determination process is ended.

If it is determined in step S4 that the acquired information does not satisfy any of the second to fourth update criteria, the process proceeds to No in step S4. Then, in step S5, the storage necessity determination unit 108 of the dealer 100 determines whether the storage criterion for rebuilding is satisfied. If it is determined that the storage criterion for rebuilding is satisfied, the process proceeds to Yes in step S5, and it is determined in the above-described step S3 that the association process is to be performed, and the preliminary determination process is ended.

On the other hand, if it is determined in step S5 that the storage criterion for rebuilding is not satisfied, the process proceeds to No in step S5, and it is determined in step S6 that a discard or recycling process is to be performed, and the preliminary determination process is ended.

### 2-2. Post Preliminary Determination Process

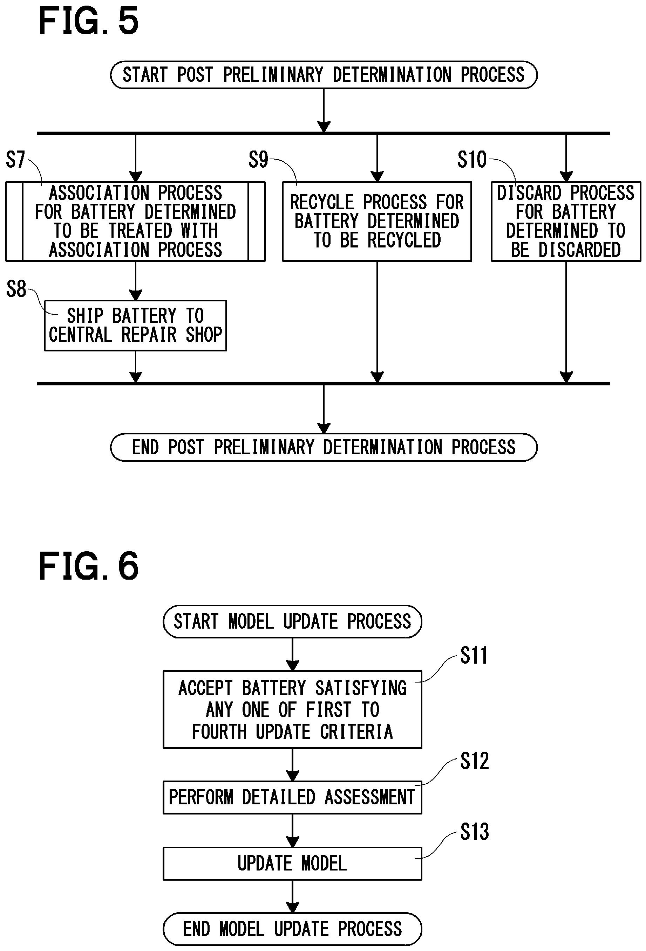

Next, a post preliminary determination process in the control flow of the vehicle battery assessment system 1 will be described. As shown in FIG. 5, the post preliminary determination process includes parallel processes of steps S7 to S8, step S9, and step S10. In step S7, which is a first parallel process, the battery 11 determined to be treated with the association process in step S3 described above is removed from the vehicle, and then the association process, which will be described later, is performed. Thereafter, in step S8, the battery 11 is shipped to the central repair shop 300. In step S9, which is a second parallel process, the battery 11 determined to be recycled in step S6 described above is removed from the vehicle, and the parts are taken out by disassembly or the like, and the recycling process is carried out to reuse the parts. In step S10, which is a third parallel process, the battery 11 determined to be discarded in step S6 described above is removed from the vehicle and discarded.

### 2-3. Model Update Process

Next, a model update process in the control flow of the vehicle battery assessment system 1 will be described. As shown in FIG. 6, the model update process begins with step S11 in which the central repair shop 300 accepts the battery 11 that satisfies any one of the first to fourth update criteria from the dealer 100. Thereafter, in step S12, the battery assessment unit 305 of the central repair shop 300 performs the detailed assessment of the battery 11. The result of the detailed assessment is stored in the information integration unit 201 of the server 200. In the first embodiment, the degree of deterioration of the battery 11 is calculated as an assessment result to assess the remaining life. Then, in step S13, the model update unit 202 updates the learned model based on the assessment result, and the model update process is ended.

### 2-4. Stock Update Process

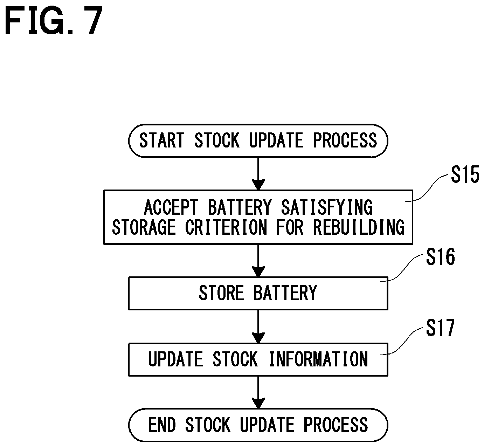

Next, a stock update process in the control flow of the vehicle battery assessment system 1 will be described. As shown in FIG. 7, the model update process begins with step S15, in which the central repair shop 300 accepts the battery 11 that satisfies the storage criterion for rebuilding from the dealer 100. Thereafter, in step S16, the battery 11 is stored in the battery storage unit 306 of the central repair shop 300 as a stock for rebuilding. Then, in step S17, the stock information acquisition unit 204 of the server 200 acquires the stock information from the battery storage unit 306 and updates the stock information. Based on the stock information, the stock target creation unit 205 creates the stock target, updates the storage criterion for rebuilding, and ends the stock update process.

It should be noted that, for the batteries 11 shipped to the central repair shop 300 for the model update process shown in FIG. 6, a determination may be made as to whether the batteries 11 satisfy the storage criterion for rebuilding in step S5 shown in FIG. 4, and if the batteries 11 satisfy the storage criterion for rebuilding, the stock update process shown in FIG. 7 may be applied, and the batteries 11 may be stored in the battery storage unit 306 as stock for rebuilding as necessary.

In addition, in step S15, the batteries 11 that satisfy the storage criterion for rebuilding and are shipped to the central repair shop 300 may also be treated with the detailed assessment by the remaining life assessment unit 105, and the batteries 11 may be stored in the battery storage unit 306 with a ranking based on the results of the detailed assessment.

### 2-5. Remaining Life Assessment and Rebuilding

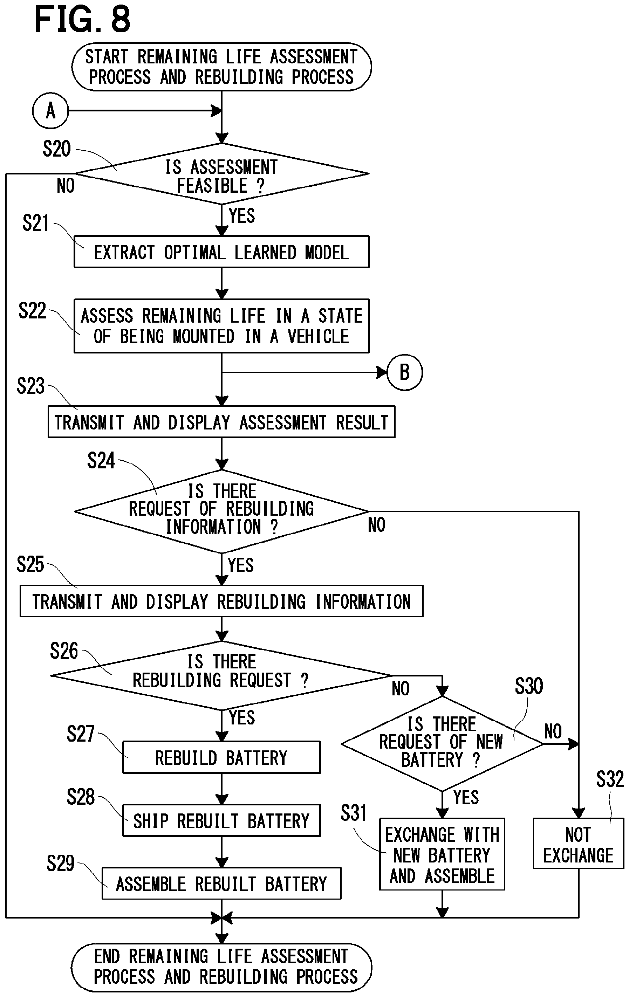

A remaining life assessment process and a rebuilding process in the control flow of the vehicle battery assessment system 1 will be described below. In step S1 shown in FIG. 4, after the information acquisition unit 101 of the dealer 100 acquires the vehicle information of the vehicle 10, the usage history information of the battery 11, and the battery characteristics of the battery 11, and the process proceeds to step S20 in FIG. 8.

Then, in step S20, the assessment feasibility determination unit 102 determines whether the assessment of the battery 11 is feasible based on the above-described information acquired by the information acquisition unit 101. If it is determined that the assessment of the battery 11 is not feasible, the process proceeds to No in step S20, and the flow ends.

On the other hand, if it is determined in step S20 that the assessment of the battery 11 is feasible, the process proceeds to Yes in step S20. Then, in step S21, the learned model extraction unit 104 extracts the optimal learned model.

Then, in step S22, the remaining life assessment unit 105 of the dealer 100 assesses the remaining life of the battery 11 in a state where the battery 11 is installed in the vehicle based on the information acquired by the information acquisition unit 101 and the optimal learned model. Then, in step S23, the assessment result output unit 106 outputs the assessment result to the display unit (not shown) and also transmits it to the information integration unit 201 of the server 200.

Thereafter, in step S24, the rebuilding information request input unit 120 of the dealer 100 determines whether there is a request from the user for rebuilding information that will serve as a basis for deciding whether to order a rebuilt battery. If there is the request for the rebuilding information, the process proceeds to Yes in step S24, and in step S25, the rebuilding information creation unit 302 of the central repair shop 300 creates the rebuilding information, and the information transmission unit 303 transmits the rebuilding information to the dealer 100. The rebuilding information also includes information on the delivery time and the cost when using a new battery in place of the rebuilt battery. The information reception unit 122 of the dealer 100 receives the rebuilding information, and the information presentation unit 123 presents the rebuilding information to the user. The user can decide whether to rebuild the battery by taking into consideration the delivery time and the cost of the rebuilt battery contained in the rebuilding information.

Then, in step S26, the rebuilding request reception and transmission unit 124 of the dealer 100 determines whether a rebuilding request indicating an intention to carry out rebuilding has been input by the user. If the rebuilding request has been input by the user, the process proceeds to Yes in step S26, and the rebuilding request is transmitted to the central repair shop 300. When the rebuilding request is received by the rebuilding unit 307 of the central repair shop 300, in step S27, the battery corresponding to the rebuilding request is extracted from the plurality of batteries stored in the battery storage unit 306 in the central repair shop 300, and a rebuilt battery is created based on this battery. Alternatively, a number of rebuilt batteries of various ranks may be created in advance by combining a number of batteries that have been determined to be stored in the battery storage unit 306, and these rebuilt batteries may be stored in the battery storage unit 306, and from these stored rebuilt batteries, the rebuilt battery corresponding to the rebuilding requirement may be extracted. Thereafter, in step S28, the created or extracted rebuilt battery is shipped by the rebuilt battery shipping unit 308 from the central repair shop 300 to the dealer 100.

Then, at the dealer 100, after the acceptance unit 125 receives the rebuilt battery, the assembly unit 126 of the dealer 100 forms a battery pack 12 using the rebuilt battery and assembles the battery pack 12 into the vehicle 10 in step S29. Then, this processing flow is ended.

On the other hand, if there is no rebuilding request input from the user in step S26, the process proceeds to No in step S26, and in step S30, the rebuilding request reception and transmission unit 124 determines whether the user requests to replace the battery with a new battery. If the user requests to replace the battery with a new battery, the process proceeds to Yes in step S30, and in step S31, the new battery order unit 127 of the dealer 100 places an order for a new battery to a battery manufacturer (not shown). After the new battery arrives at the dealer 100, the new battery is accepted by the acceptance unit 125, and the assembly unit 126 forms the battery pack 12 using the new battery and assembles the battery pack 12 into the vehicle 10. Then, this processing flow is ended. If, in step S30, the user does not request to replace the battery with a new battery, the process proceeds to No in step S30, and it is determined in S32 that the battery 11 will not be replaced, and this processing flow is ended.

In step S24, if there is no request for rebuilding information from the user, the process proceeds to No in step S24, and it is determined in step S32 that the battery 11 will not be replaced, and this processing flow is ended.

In the first embodiment, the battery stored in the battery storage unit 306 is used in response to the rebuilding request from the user. However, instead of this example, the battery 11 initially installed in vehicle 10 of the user may be sent to the central repair shop 300, a part of the battery 11 may be replaced and repaired, and then the battery 11 may returned to the user as a rebuilt battery.

### 2-6. Association Process

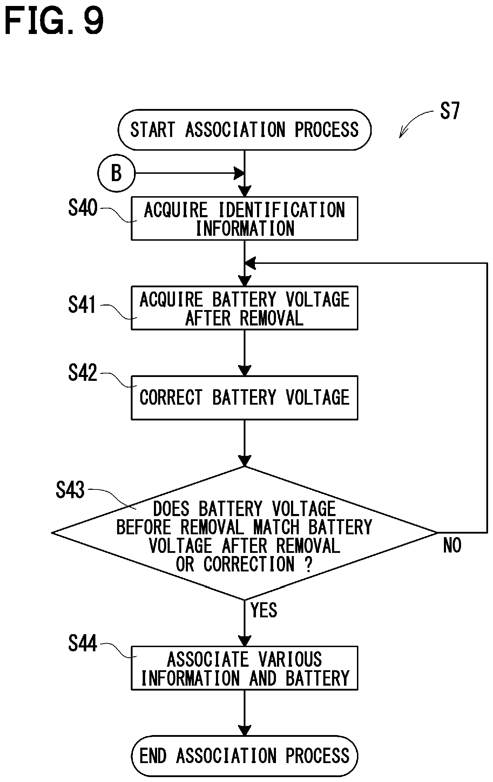

Next, the association Process in step S7 shown in FIG. 4 will be described with reference to FIG. 9. First, in step S22 shown in FIG. 8, the remaining life assessment unit 105 of the dealer 100 assesses the remaining life of the battery 11 in the state where the battery 11 is installed in the vehicle 10, and stores the assessment result in the information integration unit 201 of the server 200. After that, the process proceeds to step S40 in FIG. 9 as indicated by symbol B. Then, in step S40, the association information acquisition unit 109 of the dealer 100 acquires the battery identification information of the battery 11 removed from the vehicle 10.

Then, in step S41, the battery voltage of the removed battery 11 is directly measured and obtained as a direct battery characteristic. Then, in step S42, in order to take into account a change in the battery voltage as the direct battery characteristic that occurs over time from when the battery 11 is removed from the vehicle 10 to when the battery voltage is measured, the battery voltage as the direct battery characteristic is corrected in accordance with elapse of time. If the elapsed time is shorter than a predetermined reference value, the change in the battery voltage that accompanies the elapse of time may be ignored and step S42 may not be performed.

Thereafter, in step S43, the battery voltage before removal and after removal or correction are compared to determine whether they match. If it is determined that they match, the process proceeds to Yes in step S43, and in step S44, it is associated that the information obtained before removal from the vehicle 10 match the information of the battery 11 after removal, and then this processing flow is ended.

On the other hand, if it is determined in step S43 that the battery voltage before removal and the battery voltage after removal or correction do not match, the information obtained before removal from the vehicle 10 does not match the information of the battery 11 after removal, so the two are not associated, the process returns to step S41 where the battery voltage after removal is acquired again, and the battery voltage after removal is corrected in step S42. Then, in step S43, the corrected battery voltage after removal is compared with the battery voltage before removal of the battery 11 other than the battery previously compared, to determine whether the battery voltages match. Based on the result of the comparison, step S44 or step S41 and subsequent steps are carried out again as described above.

In the present embodiment, the association process in step S7 is performed at the dealer 100, but the present disclosure is not limited to the above example, and the association process may be performed at the central repair shop 300 after the battery 11 is shipped from the dealer 100 to the central repair shop 300.

Next, the effects of the vehicle battery assessment system 1 according to the first embodiment will be described in detail. In the vehicle battery assessment system 1 of the first embodiment, the remaining life of the battery 11 installed in the vehicle 10 is assessed based on at least the information about the vehicle 10 in which the battery 11 is installed, the usage history information of the battery 11, and the learned model that is created in advance. This makes it possible to assess the remaining life of the battery 11 with high accuracy in a short period of time.

In addition, in the first embodiment, the assessment feasibility determination unit 102 that determines whether the remaining life of the battery 11 is feasible is provided, and the remaining life assessment unit 105 assesses the remaining life of the battery 11 for which it is determined by the assessment feasibility determination unit 102 that the assessment is feasible. This makes it possible to avoid assessing the remaining life of the battery 11 that us an excessively deteriorated or damaged, thereby improving the efficiency of the arithmetic processing.

In addition, in the first embodiment, the learned model acquisition unit 103 acquires multiple learned models that have been created in advance. The vehicle battery assessment system 1 also includes the learned model extraction unit 104 that extracts at least one learned model from the multiple learned models acquired by the learned model acquisition unit 103 based on the information acquired by the information acquisition unit 101. Furthermore, the remaining life assessment unit 105 uses the learned model extracted by the learned model extraction unit 104 as the learned model. This allows the remaining life assessment unit 105 to assess the remaining life based on the optimal learned model corresponding to the information acquired by the information acquisition unit 101, thereby improving the accuracy of the assessment.

In addition, in the first embodiment, the vehicle battery assessment system 1 includes the model update unit 202 that updates the learned model based on the information acquired by the information acquisition unit 101. As a result, even if the deterioration trend of the battery 11 changes, the learned model is updated accordingly. Thus, the remaining life can be assessed with higher accuracy.

In addition, in the first embodiment, the vehicle battery assessment system 1 includes the update necessity determination unit 107 that determines whether the battery 11 is necessary for updating the learned model. Accordingly, the detailed assessment is performed only on the battery11 that is required for updating, and the efficiency of arithmetic processing can be improved.

In addition, in the first embodiment, the update necessity determination unit 107 determines that an update of the learned model is necessary when at least one of the following criteria is satisfied: when the information acquired by the information acquisition unit is information belonging to an unlearned domain in a learned model; when the information belongs to a learned domain in the learned model, and a data distance between a data center calculated from information within a predetermined period from the latest model update and a data center calculated from all information in the learned domain is equal to or greater than a reference value; when the information belongs to the learned domain in the learned model, and a difference between a data distortion calculated from information within a predetermined period from the latest model update and a data distortion calculated from all the information in the learned domain is equal to or greater than a reference value; and when the information belongs to the learned domain in the learned model, and a difference between a data density calculated from information within a predetermined period from the latest model update and a data density calculated from all the information in the learned domain is equal to or greater than a reference value. This makes it possible to optimize the extraction of the battery 11 required to update the learned model, thereby further improving the accuracy of the assessment of the remaining life.

Moreover, in the first embodiment, the vehicle battery assessment system 1 includes the storage necessity determination unit 108 that determines whether the battery 11 should be stored in the stock for rebuilding the battery 11. This makes it possible to restrict surplus batteries from being stored for rebuilding.

Furthermore, in the first embodiment, the storage necessity determination unit 108 determines whether the battery 11 needs to be rebuilt based on the stock target calculated according to the stock information of the batteries stored as the stock for rebuilding. This makes it possible to efficiently acquire and store batteries having battery characteristics that are in short supply in the stock for rebuilding, while also restricting excess stock and optimizing stock management.

Furthermore, in the first embodiment, the batteries stored in the battery storage unit 306 in the central repair shop 300 are ranked based on the assessment results of the batteries 11, and the stock information includes the number of batteries for each rank. The storage criterion for rebuilding, which is the criterion for determining whether a battery should be stored in the stock for rebuilding, also stipulate the number of batteries for each rank. In other words, the storage criterion for rebuilding is stipulated based on the stock status in the battery storage unit 306 and the assessment results of the batteries 11. As a result, the battery stock management can be performed taking into consideration the rank of the batteries 11, making it possible to further optimize the stock management.

In the first embodiment, the information acquisition unit 101 further acquires the battery characteristics of the battery 11 as the above-described information. Accordingly, the remaining life can be assessed with taking into account the battery characteristics. Thus, the accuracy of the assessment can be further improved.

In addition, in the first embodiment, the vehicle battery assessment system 1 further includes the association information acquisition unit 109 that compares the battery characteristic acquired by the information acquisition unit 101 from the battery 11 in a state of being installed in the vehicle 10 with the direct battery characteristic acquired by directing measuring the battery characteristic of the battery 11 removed from the vehicle 10, and associates the information acquired by the information acquisition unit 101 with the battery identification information of the battery 11. Accordingly, it is possible to ensure that the information acquired from the battery 11 in the state of being installed in the vehicle 10, where it is difficult to physically identify the battery 11, is the information about the battery 11 in question, thereby preventing mix-ups of the batteries 11 and improving the reliability of the assessment results.

In addition, in the first embodiment, the association information acquisition unit 109 uses, as the direct battery characteristic, the battery characteristic obtained by directly measuring the battery 11 and corrected based on the elapsed time from when the battery 11 is removed from the vehicle 10 to when the battery 11 is directly measured. Accordingly, it is possible to improve the accuracy of the association even when using the battery characteristic obtained some time after removal from the vehicle 10, thereby mix-ups of the batteries 11 and improving the reliability of the assessment results.

As described above, according to the first embodiment, it is possible to provide the vehicle battery assessment system 1 capable of assessing the remaining life of the battery 11 installed on the vehicle 10 with high accuracy.

The present disclosure is not limited to each of the above embodiments, and can be applied to various embodiments without departing from the gist thereof.

Features of the present disclosure will be described below.

### [Item 1]

A vehicle battery assessment system (1) for assessing a remaining life of a battery installed in a vehicle (10), includes an information acquisition unit (101) configured to acquire information including at least vehicle information of the vehicle and usage history information of the battery, a learned model acquisition unit (103) configured to acquire a learned model that is created in advance by setting at least the vehicle information of the vehicle in which the battery is installed and the usage history information of the battery as explanatory variables and setting the remaining life of the battery as a target variable, a remaining life assessment unit (105) configured to assess the remaining life of the battery based on the vehicle information and the usage history information acquired by the information acquisition unit and the learned model, and an assessment result output unit (106) configured to output an assessment result of the remaining life assessment unit.

### [Item 2]

The vehicle battery assessment system according to item 1 further includes an assessment feasibility determination unit (102) configured to determine whether an assessment of the remaining life of the battery is feasible. The remaining life assessment unit is configured to assess the remaining life of the battery for which the assessment feasibility determination unit determines that the assessment is feasible.

### [Item 3]

In the vehicle battery assessment system according to item 1 or 2, the learned model acquisition unit is configured to acquire a plurality of learned models created in advance. The vehicle battery assessment system further includes a learned model extraction unit (104) configured to extract at least one of the plurality of learned models acquired by the learned model acquisition unit based on the information acquired by the information acquisition unit. The remaining life assessment unit is configured to use, as the learned model, the at least one of the plurality of learned models extracted by the learned model extraction unit.

### [Item 4]

The vehicle battery assessment system according to any one of items 1 or 3 further includes a model update unit (202) configured to update the learned model based on the information acquired by the information acquisition unit.

### [Item 5]

The vehicle battery assessment system according to item 4 further includes an update necessity determination unit (107) configured to determine whether the battery is necessary for updating the learned model.

### [Item 6]

In the vehicle battery assessment system according to item 5, the update necessity determination unit is configured to determine that updating of the learned model is necessary when the information acquired by the information acquisition unit satisfies at least one of following criteria:
when the information belongs to an unlearned domain in the learned model;
when the information belongs to a learned domain in the learned model, and a data distance between a data center calculated from information within a predetermined period from a latest model update and a data center calculated from all information in the learned domain is equal to or greater than a reference value;
when the information belongs to the learned domain in the learned model, and a difference between a data distortion calculated from information within a predetermined period from the latest model update and a data distortion calculated from all the information in the learned domain is equal to or greater than a reference value; and
when the information belongs to the learned domain in the learned model, and a difference between a data density calculated from information within a predetermined period from the latest model update and a data density calculated from all the information in the learned domain is equal to or greater than a reference value.

### [Item 7]

The vehicle battery assessment system according to any one of items 1 to 6 further includes a storage necessity determination unit (108) configured to determine whether the battery is necessary to be stored in a stock for rebuilding the battery.

### [Item 8]

In the vehicle battery assessment system according to item 7, the storage necessity determination unit is configured to determine whether the battery is necessary for rebuilding based on a stock target calculated according to stock information of the battery stored as the stock for rebuilding.

### [Item 9]

In the vehicle battery assessment system according to any one of items 1 to 8, the information acquisition unit further acquires a battery characteristic of the battery.

### [Item 10]

The vehicle battery assessment system according to item 9, further includes an association information acquisition unit (109) configured to compare the battery characteristic acquired by the information acquisition unit from the battery in a state of being installed in the vehicle with a direct battery characteristic acquired by removing the battery from the vehicle and directly measuring the battery, and associate the information acquired by the information acquisition unit with battery identification information of the battery.

### [Item 11]

In the vehicle battery assessment system according to item 10, the association information acquisition unit is configured to use, as the direct battery characteristic, a battery characteristic acquired by directly measuring the battery and corrected based on a elapsed time from when the battery is removed from the vehicle to when the battery is directly measured.

Although the present disclosure has been described in accordance with the embodiments, it is understood that the present disclosure is not limited to such embodiments or structures. The present disclosure also includes various modified embodiments and a modification within an equivalent scope. In addition, while various combinations and configurations, which are preferred, other combinations and configurations including further only a single element, more or less, are also within the spirit and scope of the present disclosure.

## Claims

1. A vehicle battery assessment system (1) for assessing a remaining life of a battery installed in a vehicle (10), comprising:
an information acquisition unit (101) configured to acquire information including at least vehicle information of the vehicle and usage history information of the battery;
a learned model acquisition unit (103) configured to acquire a learned model that is created in advance by setting at least the vehicle information of the vehicle in which the battery is installed and the usage history information of the battery as explanatory variables and setting the remaining life of the battery as a target variable;
a remaining life assessment unit (105) configured to assess the remaining life of the battery based on the vehicle information and the usage history information acquired by the information acquisition unit and the learned model; and
an assessment result output unit (106) configured to output an assessment result of the remaining life assessment unit.

2. The vehicle battery assessment system according to claim 1, further comprising an assessment feasibility determination unit (102) configured to determine whether an assessment of the remaining life of the battery is feasible, wherein
the remaining life assessment unit is configured to assess the remaining life of the battery for which the assessment feasibility determination unit determines that the assessment is feasible.

3. The vehicle battery assessment system according to claim 1 or 2, wherein
the learned model acquisition unit is configured to acquire a plurality of learned models created in advance,
the vehicle battery assessment system further comprising a learned model extraction unit (104) configured to extract at least one of the plurality of learned models acquired by the learned model acquisition unit based on the information acquired by the information acquisition unit, wherein
the remaining life assessment unit is configured to use, as the learned model, the at least one of the plurality of learned models extracted by the learned model extraction unit.

4. The vehicle battery assessment system according to claim 1 or 2, further comprising a model update unit (202) configured to update the learned model based on the information acquired by the information acquisition unit.

5. The vehicle battery assessment system according to claim 4, further comprising an update necessity determination unit (107) configured to determine whether the battery is necessary for updating the learned model.

6. The vehicle battery assessment system according to claim 5, wherein the update necessity determination unit is configured to determine that updating of the learned model is necessary when the information acquired by the information acquisition unit satisfies at least one of following criteria:
when the information belongs to an unlearned domain in the learned model;
when the information belongs to a learned domain in the learned model, and a data distance between a data center calculated from information within a predetermined period from a latest model update and a data center calculated from all information in the learned domain is equal to or greater than a reference value;
when the information belongs to the learned domain in the learned model, and a difference between a data distortion calculated from information within a predetermined period from the latest model update and a data distortion calculated from all the information in the learned domain is equal to or greater than a reference value; and
when the information belongs to the learned domain in the learned model, and a difference between a data density calculated from information within a predetermined period from the latest model update and a data density calculated from all the information in the learned domain is equal to or greater than a reference value.

7. The vehicle battery assessment system according to claim 1 or 2, further comprising a storage necessity determination unit (108) configured to determine whether the battery is necessary to be stored in a stock for rebuilding the battery.

8. The vehicle battery assessment system according to claim 7, wherein the storage necessity determination unit is configured to determine whether the battery is necessary for rebuilding based on a stock target calculated according to stock information of the battery stored as the stock for rebuilding.

9. The vehicle battery assessment system according to claim 1 or 2, wherein the information acquisition unit further acquires a battery characteristic of the battery.

10. The vehicle battery assessment system according to claim 9, further comprising an association information acquisition unit (109) configured to compare the battery characteristic acquired by the information acquisition unit from the battery in a state of being installed in the vehicle with a direct battery characteristic acquired by removing the battery from the vehicle and directly measuring the battery, and associate the information acquired by the information acquisition unit with battery identification information of the battery.

11. The vehicle battery assessment system according to claim 10, wherein the association information acquisition unit is configured to use, as the direct battery characteristic, a battery characteristic acquired by directly measuring the battery and corrected based on a elapsed time from when the battery is removed from the vehicle to when the battery is directly measured.
